# FASCICULE DE BREVET EUROPEEN

(11) **EP 1 455 561 B1**
(45) Date de publication et mention de la délivrance du brevet: **08.06.2011**
(21) Numéro de dépôt: 04290511.7
(22) Date de dépôt: 25.02.2004
(51) Int. Cl.: H05K 7/20, H05K 7/14

(54) **Module électronique de puissance avec bornes de connexion**
Leistungselektronikeinheit mit Anschlussklemmen
Power electronic module with connecting terminals

(30) Priorité: 03.03.2003 FR 0302527
(43) Date de publication de la demande: 08.09.2004
(73) Titulaire: Renault s.a.s., 92100 Boulogne Billancourt (FR)
(72) Inventeur: Lecoq, Frédéric, 78180 Montigny le Bretonneux (FR)
(74) Mandataire: Religieux, Vincent

(56) Documents cités:
- EP-A- 0 841 842
- DE-A- 19 628 549
- US-A- 5 872 711
- US-A- 5 966 291

## Description

L'invention concerne module électronique de puissance, et en particulier une disposition particulière de borne de connexion dans un tel module.

Un module électronique de puissance permet de fournir à un récepteur un courant électrique modulé en fonction des besoins. Par exemple, un tel module peut intervenir dans l'alimentation d'un moteur électrique pour lequel la puissance, le couple ou la vitesse de rotation doit être modulée. Cette modulation est réalisée par des composants électroniques intégrés au module. Du fait des courants importants qui y circulent, ces composants dégagent une chaleur importante, qu'il faut évacuer pour limiter la température atteinte par les composants et éviter leur détérioration.

Dans le cas d'une alimentation en courant continu, comme par exemple dans un véhicule automobile électrique ou hybride, des condensateurs sont prévus en parallèle avec des accumulateurs électriques, pour filtrer les appels de courants, en particulier dans les hautes fréquences. De tels condensateurs subissent également un échauffement et doivent être refroidis pour éviter leur détérioration. De plus, ils doivent être placés à proximité immédiate du module pour être efficaces.

Le document EP 1129891 montre un module de puissance comportant des composants électroniques et des condensateurs. Les condensateurs sont reliés électriquement aux composants électroniques par deux barres ayant une section en Z. Ainsi, les condensateurs sont reliés aux composants électroniques au plus près. Cependant, aucune disposition n'est prévue pour le refroidissement des condensateurs. De plus, le module est prévu avec des bornes de connexion supplémentaires vers des appareils électriques extérieurs au module.

Dans le document EP 841842, des composants électroniques de puissance sont refroidis en étant en contact avec un radiateur traversé par un liquide de refroidissement. Le refroidissement des composants est ainsi bien assuré. Cependant, rien n'est prévu pour disposer et refroidir des condensateurs.

DE-A-19628549 divulgue un module électrique selon la première partie de la revendication 1.

C'est donc un objectif de l'invention d'améliorer un module de puissance refroidi par un liquide de refroidissement pour qu'il dispose de condensateurs connectés de manière efficace et protégés d'une surchauffe.

Avec cet objectif en vue, l'invention a pour objet module électronique de puissance comportant une embase, au moins un composant électronique de puissance fixé sur une première face de l'embase, un circuit de refroidissement dans l'embase et dans lequel un fluide de refroidissement est destiné à circuler pour refroidir le composant électronique, et des bornes de connexion reliées électriquement au composant électronique, caractérisé en ce qu'au moins un condensateur est connecté aux dites bornes de connexion, le circuit de refroidissement comportant une face de refroidissement opposée à la première face, le condensateur étant en regard de la face de refroidissement, chaque borne de connexion comportant au moins un premier moyen de connexion ayant une première face d'accès à proximité de la face de refroidissement pour la connexion du condensateur.

Grâce à l'invention, le condensateur peut être refroidi par la face de refroidissement. De plus, la connexion du condensateur est réalisée à proximité immédiate des composants électroniques, ce qui permet d'obtenir une efficacité optimale des condensateurs pour le filtrage du courant électrique.

Dans un mode de réalisation préféré, la face d'accès du premier moyen de connexion est perpendiculaire à la face de refroidissement. Ainsi, le moyen de connexion est très accessible pour la fixation de la connexion du condensateur, par le côté de l'embase. Le condensateur peut occuper toute la surface de la face de refroidissement, sans prévoir de dégagement pour l'accès au moyen de connexion.

Plus particulièrement, l'embase comporte une face latérale perpendiculaire à la face de refroidissement, la face d'accès du premier moyen de connexion étant parallèle et en retrait par rapport à la face latérale de l'embase. Ainsi, une patte en provenance du condensateur venant en contact avec le moyen de connexion sur la face d'accès peut ne pas dépasser par rapport à la face latérale de l'embase. L'intégration du module en est facilitée, avec une occupation optimale de l'espace.

C'est un autre objectif de l'invention de simplifier la connexion des appareils électriques extérieurs au module.

Avec cet objectif en vue, la borne de connexion comporte un deuxième moyen de connexion ayant une deuxième face d'accès sensiblement dans le plan de la première face. Ce deuxième moyen de connexion peut servir pour une connexion du module vers des appareils extérieurs tels que des accumulateurs ou un récepteur. Sa disposition près de la première face en fait un moyen de connexion directement accessible par l'extérieur, sans utiliser de borne de report intermédiaire.

Selon un mode de réalisation particulier, la borne de connexion comporte une bande de métal pliée. Le moyen de connexion comporte un écrou soudé sur la bande de métal, la face d'accès étant perpendiculaire à un axe de l'écrou. La connexion est réalisable par le serrage d'un élément de liaison électrique par une vis engagée dans l'écrou.

De manière particulière, la borne de connexion comporte une zone de soudure pour recevoir des fils de liaison en provenance des composants électroniques de puissance.

De manière avantageuse, l'embase est réalisée en matière synthétique et la borne est insérée dans l'embase par surmoulage. Les faces d'accès des moyens de connexion et la zone de soudure restent à nu.

De manière particulière, l'embase a une forme de parallélépipède rectangle et comporte quatre bornes de connexion couplées deux à deux disposées aux quatre angles de la première face.

Le module comporte un boîtier dans lequel l'embase est insérée et fixée, de telle sorte que les deuxièmes moyens de connexion affleurent un bord supérieur du boîtier, le condensateur étant situé dans le boîtier sous l'embase. Ainsi, les deuxièmes moyens de connexion sont facilement accessibles, tandis que l'embase et le condensateur sont bien protégés. Les éléments de liaison électriques connectés sur les deuxièmes moyens de connexion s'éloignent du module en passant à proximité du bord supérieur du boîtier. Ils sont ainsi faciles à masquer, par exemple par un capot rejoignant le boîtier le long du bord supérieur.

L'invention sera mieux comprise et d'autres particularités et avantages apparaîtront à la lecture de la description qui va suivre, la description faisant référence aux dessins annexés parmi lesquels :
- la figure 1 est une vue en perspective d'un module conforme à l'invention ;
- la figure 2 est une vue en perspective et en éclaté du module de la figure 1 ;
- la figure 3 est une vue de dessus, sans capot, d'une embase du module de la figure 1 ;
- la figure 4 est une vue en perspective de l'embase de la figure 3 ;
- la figure 5 est une vue de face de l'embase de la figure 3 ;
- la figure 6 est une vue en perspective d'une connexion intégrée à l'embase de la figure 3 ;
- la figure 7 est une vue partielle en coupe selon la ligne VII-VII de la figure 5.

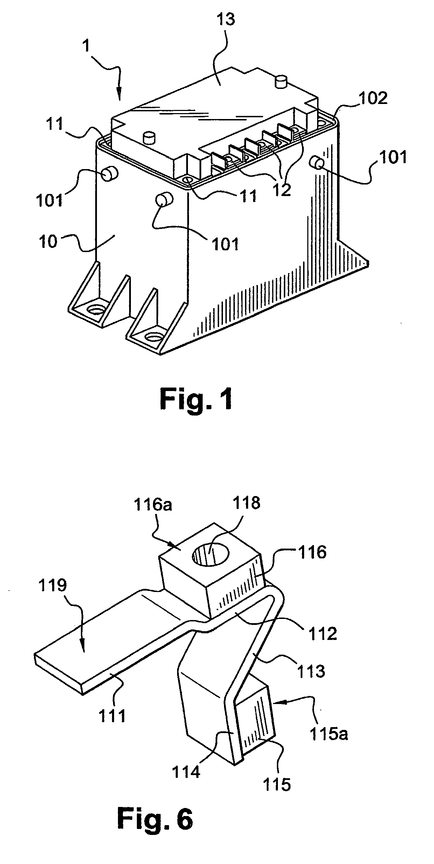

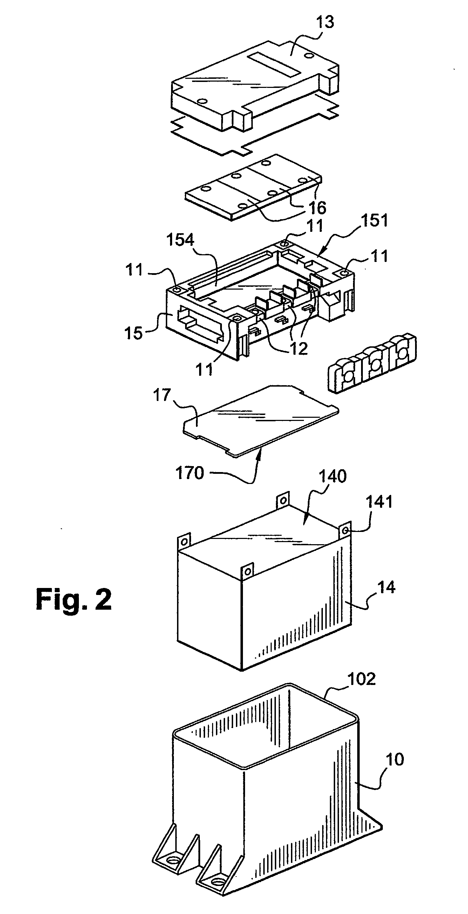

Un module 1 électronique de puissance conforme à l'invention est montré sur les figures 1 et 2. Ce module 1 comporte un boîtier 10 de forme parallélépipédique rectangle dont la face supérieure est ouverte. Il comporte également des bornes de connexion d'entrée 11 situées aux quatre sommets de la face supérieure et ayant une face d'accès 116a sensiblement dans le plan de la face supérieure du module 1. Le module 1 comporte également six bornes de connexion de sortie 12 le long d'un bord de la face supérieure. Un capot 13 est fixé au niveau de la face supérieure et fait saillie par rapport à la face supérieure.

Les éléments internes du module apparaissent sur la figure 2 en éclaté. Le module 1 comporte un condensateur 14 de forme parallélépipédique rectangle et une embase 15 surmontée par le capot 13. Le condensateur 14 est fixé à l'embase 15, d'une manière qui sera détaillée ci-après. L'ensemble formé par l'embase 15 et le condensateur 14 est contenu dans le boîtier 10 et fixé par exemple par les vis 101 traversant le boîtier 10.

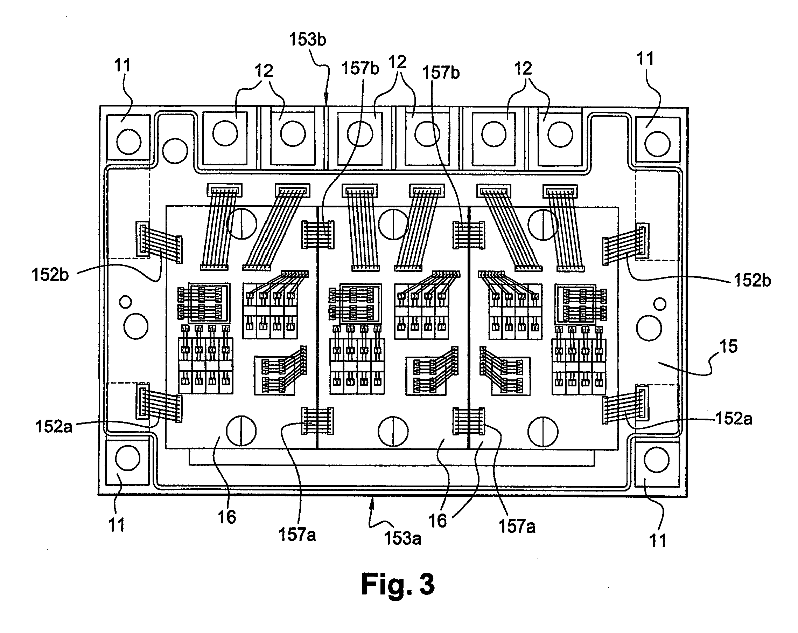

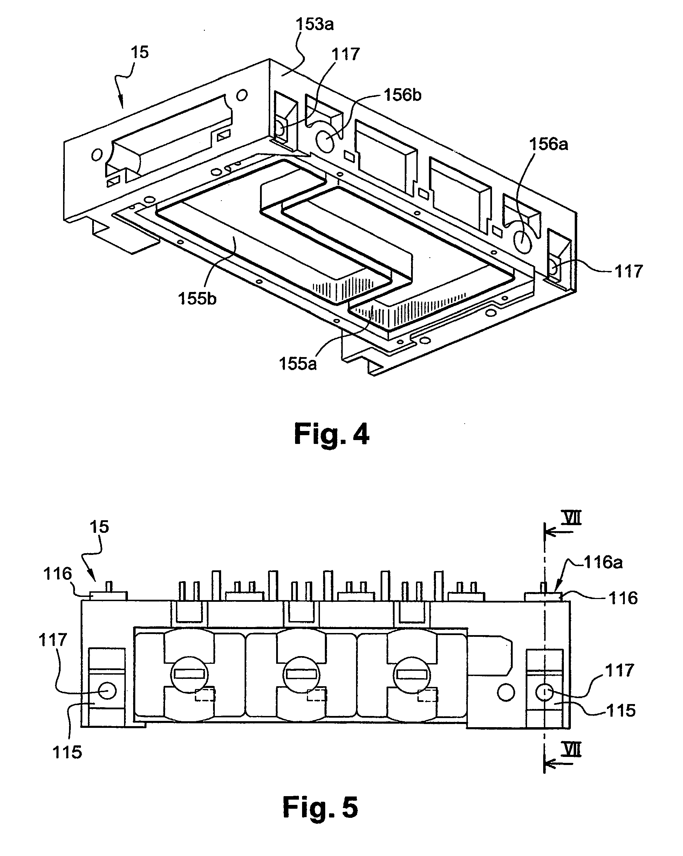

L'embase 15, représentée sur les figures 3 à 5, est une pièce obtenue par moulage d'une résine synthétique. Elle comporte des composants électroniques de puissance pour commuter un courant électrique. Les composants électroniques sont répartis sur trois éléments 16, disposés côte à côte et fixés dans une cavité 154 d'une première face 151 de l'embase 15. L'embase 15 comporte également les bornes de connexion d'entrée 11 et de sortie 12. Les bornes de connexion 11, 12 sont des pièces métalliques, par exemple en cuivre, insérées dans l'embase 15 par surmoulage.

Un circuit de refroidissement est prévu dans l'embase 15 pour refroidir les composants électroniques et le condensateur 14. Ce circuit de refroidissement comporte deux cavités de refroidissement 155a, 155b, et deux conduits d'alimentation 156a, 156b. Une plaque de fermeture 17, de préférence métallique, ferme les cavités 155a, 155b en formant une face de refroidissement 170. Des orifices, non représentés, sont prévus pour la circulation d'un fluide de refroidissement d'une cavité 155a à l'autre 155b.

La figure 6 montre en détail la borne d'entrée 11, avant surmoulage. La borne d'entrée 11 est formée par pliage d'une bande plate métallique, par exemple en cuivre. Elle comporte une première zone plate 111, appelée également zone de soudure, prolongée par une deuxième zone 112 parallèle à la première zone 111 et décalée vers le bas. La deuxième zone 112 est prolongée par un retour 113 formant un angle aigu avec la deuxième zone 112. Enfin, une troisième zone 114 prolonge le retour 113 dans une direction sensiblement perpendiculaire à la première zone 111.

Un premier écrou 115 carré est rapporté sur la troisième zone 114, par exemple par soudure. Un trou taraudé 117 du premier écrou 115 a un axe sensiblement perpendiculaire à la troisième zone 114. Le premier écrou 115 comporte ainsi une face d'accès 115a parallèle à la troisième zone 114. La face d'accès 115a est en retrait par rapport au pli entre la deuxième zone 112 et le retour 113.

Un deuxième écrou 116 carré est rapporté sur la deuxième zone 112, par exemple par soudure. Un trou taraudé 118 du deuxième écrou a un axe sensiblement perpendiculaire à la deuxième zone 112. Le deuxième écrou 116 comporte ainsi une face d'accès 116a parallèle à la deuxième zone 112.

Les bornes de connexion d'entrée 11 sont surmoulées de façon à ne laisser à nu uniquement les faces d'accès 115a, 116a et une partie des premières zone de soudure 111. Les éléments 16 portant les composants électroniques sont reliés électriquement aux bornes de connexion d'entrée 11 par des fils 152a, 152b, par exemple en aluminium, soudés d'une part sur les éléments et d'autre part sur les zones de soudure 111. Le nombre de fils 152a, 152b est déterminé en fonction de l'intensité du courant à faire passer entre les bornes de connexion et les composants. Les bornes de connexion de sortie 12 sont reliées aux éléments 16 de la même manière. Une liaison électrique est établie entre deux bornes d'entrée d'une même face latérale 153a, 153b, par exemple par des ponts 157a, 157b de fils entre les éléments 16.

Les bornes de connexion d'entrée 11 sont disposées également de manière à ce que les faces d'accès 115a soient accessibles par une face latérale 153a, 153b de l'embase 15. Les faces d'accès 115a sont ainsi parallèles aux faces latérales 153a, 153b, en étant en retrait par rapport à celles-ci.

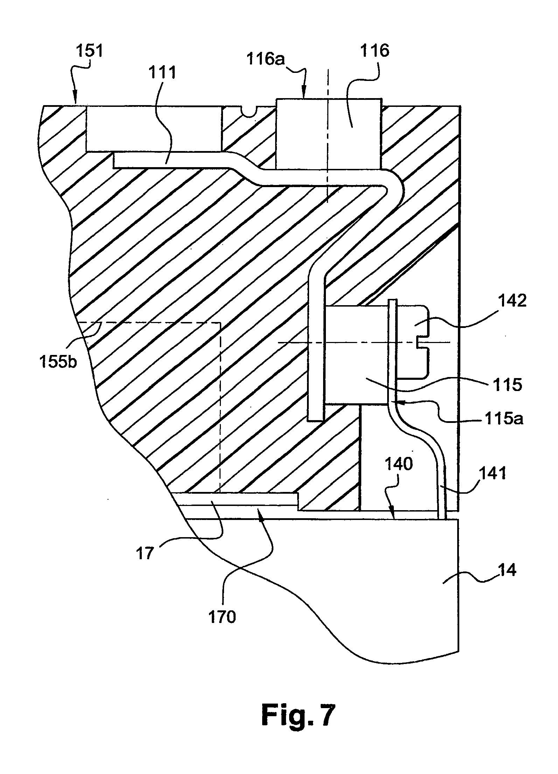

Le condensateur 14 peut être réalisé d'un seul bloc, ou par l'assemblage d'unités élémentaires de condensateur. Il comporte quatre pattes de connexion 141 qui font saillie par rapport à une face supérieure 140. En se référant plus particulièrement à la figure 7, l'embase 15 et le condensateur 14 sont assemblés de telle sorte que la face supérieure 140 du condensateur est en regard de la face de refroidissement 170 de l'embase 15. Le condensateur 14 est connecté à l'embase 15 par des vis 142 traversant les pattes 141 et serrées dans les trous taraudés 117 de manière à établir une liaison électrique entre les bornes d'entrée et les pattes 141 du condensateur. L'accès des vis 142 est très aisé à partir des faces latérales 153a, 153b. Dans l'exemple montré, les pattes 141 comporte un escalier pour faire saillie de la face supérieure 140 du condensateur 14 au plus près du bord de ladite face 140, tout en laissant suffisamment de place pour que la tête de la vis 142 soit logée dans l'embase 15 sans faire saillie.

Le module 1 est destiné à être monté dans un véhicule automobile pour commuter un courant continu en provenance d'accumulateurs vers un moteur électrique, ou éventuellement dans un sens inverse en cas de freinage en récupérant l'énergie cinétique du véhicule pour recharger les accumulateurs. Le moteur est connecté aux bornes de sortie 12, tandis que les accumulateurs sont connectés aux bornes d'entrée 11 au niveau de la face d'accès 116a du deuxième écrou 116, par l'intermédiaire de câbles électriques, non représentés. Un système de refroidissement fait circuler un fluide de refroidissement dans l'embase par les conduits d'alimentation 156a, 156b.

Lors du fonctionnement, les composants électroniques dégagent une chaleur importante qui est évacuée par le fluide de refroidissement circulant dans les cavités. Le condensateur 14 s'échauffe également. Cependant, la plaque de fermeture 17 est refroidie par le fluide de refroidissement, et comme elle est à proximité immédiate du condensateur 14, en regard de la face supérieure 140, la chaleur générée par le condensateur 17 est aussi évacuée.

## Revendications

1. Module électronique de puissance comportant une embase (15), au moins un composant électronique (16) de puissance fixé sur une première face (151) de l'embase, un circuit de refroidissement dans l'embase (15) et dans lequel un fluide de refroidissement est destiné à circuler pour refroidir le composant électronique (16), et des bornes de connexion (11) reliées électriquement au composant électronique, **caractérisé en ce qu'**au moins un condensateur (14) est connecté aux dites bornes de connexion (11), le circuit de refroidissement comportant une face de refroidissement (170) opposée à la première face (151), 1e condensateur (14) étant en regard de la face de refroidissement (170), chaque borne de connexion (11) comportant au moins un premier moyen de connexion (115) ayant une première face d'accès (115a) à proximité de la face de refroidissement (170) pour 1a connexion du condensateur (14).

2. Module électronique de puissance selon la revendication 1, dans lequel la face d'accès (115a) du premier moyen de connexion (115) est perpendiculaire à la face de refroidissement (170).

3. Module électronique de puissance selon la revendication 2, dans lequel l'embase (15) comporte une face latérale (153a, 153b) perpendiculaire à la face de refroidissement (170), la face d'accès (115a) du premier moyen de connexion étant parallèle et en retrait par rapport à la face latérale (153a, 153b) de l'embase.

4. Module électronique de puissance selon la revendication 1, dans lequel la borne de connexion (11) comporte un deuxième moyen de connexion (116) ayant une deuxième face d'accès (116a) sensiblement dans le plan de la première face (151).

5. Module électronique de puissance selon la revendication 4, dans lequel la borne de connexion (11) comporte une bande de métal pliée.

6. Module électronique de puissance selon la revendication 5 dans lequel le moyen de connexion comporte un écrou soudé (115, 116) sur la bande de métal, la face d'accès (115a, 116a) étant perpendiculaire à un axe de l'écrou.

7. Module électronique de puissance selon la revendication 1, dans lequel la borne de connexion (11) comporte une zone de soudure (111) pour recevoir des fils de liaison (152) en provenance des composants électroniques de puissance.

8. Module électronique de puissance selon la revendication 1, dans lequel l'embase est réalisée en matière synthétique et la borne (11) est insérée dans l'embase (15) par surmoulage.

9. Module électronique de puissance selon la revendication 1, dans lequel l'embase (15) a une forme de parallélépipède rectangle et comporte quatre bornes de connexion (11) couplées deux à deux disposées aux quatre angles de la première face (151).

10. Module électronique de puissance selon la revendication 1, **caractérisé en ce qu'**il comporte un boîtier (10) dans lequel l'embase (15) est insérée et fixée, de telle sorte que les deuxièmes moyens de connexion (116a) affleurent un bord supérieur du boîtier (102), le condensateur (14) étant situé dans le boîtier (10) sous l'embase (15).

## Claims

1. Power electronic module comprising a socket (15), at least one power electronic component (16) fixed to a first face (151) of the socket, a cooling circuit in the socket (15) and in which a cooling fluid is designed to flow in order to cool the electronic component (16), and connection terminals (11) electrically linked to the electronic component, **characterized in that** at least one capacitor (14) is connected to the said connection terminals (11), the cooling circuit comprising a cooling face (170) opposite to the first face (151), the capacitor (14) being opposite the cooling face (170), each connection terminal (11) comprising at least one first connection means (115) having a first access face (115a) close to the cooling face (170) for the connection of the capacitor (14).

2. Power electronic module according to Claim 1, in which the access face (115a) of the first connection means (115) is perpendicular to the cooling face (170).

3. Power electronic module according to Claim 2, in which the socket (15) comprises a lateral face (153a, 153b) perpendicular to the cooling face (170), the access face (115a) of the first connection means being parallel and set back relative to the lateral face (153a, 153b) of the socket.

4. Power electronic module according to Claim 1, in which the connection terminal (11) comprises a second connection means (116) having a second access face (116a) substantially in the plane of the first face (151).

5. Power electronic module according to Claim 4, in which the connection terminal (11) comprises a bent metal strip.

6. Power electronic module according to Claim 5, wherein the connection means comprises a nut (115, 116) welded onto the metal strip, the access face (115a, 116a) being perpendicular to an axis of the nut.

7. Power electronic module according to Claim 1, in which the connection terminal (11) comprises a welding zone (111) for receiving connecting wires (152) originating from the power electronic components.

8. Power electronic module according to Claim 1, in which the socket is made of synthetic material and the terminal (11) is inserted into the socket (15) by overmoulding.

9. Power electronic module according to Claim 1, in which the socket (15) has a rectangular parallelepipedal shape and comprises four connection terminals (11) coupled in twos placed at the four corners of the first face (151).

10. Power electronic module according to Claim 1, **characterized in that** it comprises a casing (10) in which the socket (15) is inserted and fixed so that the second connection means (116a) are flush with a top edge (102) of the casing, the capacitor (14) being situated in the casing (10) beneath the socket (15).

## Patentansprüche

1. Elektronisches Leistungsmodul, das einen Sockel (15), mindestens ein elektronisches Leistungsbauteil (16), das auf einer ersten Seite (151) des Sockel befestigt ist, einen Kühlkreislauf im Sockel (15), in dem ein Kühlfluid fließen soll, um das elektronische Bauteil (16) zu kühlen, und Anschlussklemmen (11) aufweist, die elektrisch mit dem elektronischen Bauteil verbunden sind, **dadurch gekennzeichnet, dass** mindestens ein Kondensator (14) an die Anschlussklemmen (11) angeschlossen ist, wobei der Kühlkreislauf eine Kühlseite (170) entgegengesetzt zur ersten Seite (151) aufweist, wobei der Kondensator (14) sich gegenüber der Kühlseite (170) befindet, wobei jede Anschlussklemme (11) mindestens eine erste Anschlusseinrichtung (115) aufweist, die eine erste Zugangsseite (115a) in der Nähe der Kühlseite (170) für den Anschluss des Kondensators (14) hat.

2. Elektronisches Leistungsmodul nach Anspruch 1, bei dem die Zugangsseite (115a) der ersten Anschlusseinrichtung (115) lotrecht zur Kühlseite (170) ist.

3. Elektronisches Leistungsmodul nach Anspruch 2, bei dem der Sockel (15) eine Seitenfläche (153a, 153b) lotrecht zur Kühlseite (170) aufweist, wobei die Zugangsseite (115a) der ersten Anschlusseinrichtung parallel zu und bezüglich der Seitenfläche (153a, 153b) des Sockels nach hinten versetzt ist.

4. Elektronisches Leistungsmodul nach Anspruch 1, bei dem die Anschlussklemme (11) eine zweite Anschlusseinrichtung (116) aufweist, die eine zweite Zugangsseite (116a) im Wesentlichen in der Ebene der ersten Seite (151) hat.

5. Elektronisches Leistungsmodul nach Anspruch 4, bei dem die Anschlussklemme (11) ein gefaltetes Metallband aufweist.

6. Elektronisches Leistungsmodul nach Anspruch 5, bei dem die Anschlusseinrichtung eine Mutter (115, 116) aufweist, die auf das Metallband geschweißt ist, wobei die Zugangsseite (115a, 116a) lotrecht zu einer Achse der Mutter ist.

7. Elektronisches Leistungsmodul nach Anspruch 1, bei dem die Anschlussklemme (11) eine Schweißzone (111) aufweist, um von den elektronischen Leistungsbauteilen kommende Verbindungsdrähte (152) aufzunehmen.

8. Elektronisches Leistungsmodul nach Anspruch 1, bei dem der Sockel aus Kunststoff hergestellt ist, und die Klemme (11) durch Überformen in den Sockel (15) eingefügt wird.

9. Elektronisches Leistungsmodul nach Anspruch 1, bei dem der Sockel (15) die Form eines rechtwinkligen Parallelepipeds hat und vier paarweise gekoppelte Anschlussklemmen (11) aufweist, die an den vier Ecken der ersten Seite (151) angeordnet sind.

10. Elektronisches Leistungsmodul nach Anspruch 1, **dadurch gekennzeichnet, dass** es ein Gehäuse (10) aufweist, in das der Sockel (15) so eingefügt und befestigt ist, dass die zweiten Anschlusseinrichtungen (116a) mit einem oberen Rand des Gehäuses (102) bündig abschließen, wobei der Kondensator (14) sich im Gehäuse (10) unter dem Sockel (15) befindet.
